# EUROPEAN PATENT SPECIFICATION

(11) **EP 2 874 180 B1**
(45) Date of publication and mention of the grant of the patent: **22.07.2020**
(21) Application number: 14746326.9
(22) Date of filing: 03.02.2014
(51) Int. Cl.: C23C 16/44, C23C 16/452, H01L 21/205, C23C 16/40, C23C 16/455

(54) **THIN-FILM VAPOUR DEPOSITION METHOD**
DÜNNFILMDAMPFABSCHEIDUNGSVERFAHREN
METHODE DE DÉPÔT DE FILM MINCE EN PHASE VAPEUR

(30) Priority: 04.02.2013 KR 20130012454
(43) Date of publication of application: 20.05.2015
(73) Proprietor: Tes Co., Ltd., Yongin-si, Gyeonggi-do 449-825 (KR); Hwang, Sang-soo, Seoul 138-854 (KR); Lee, Woo-Jin, Busan 618-710 (KR); Shin, Ki-jo, Icheon-si, Gyeonggi-do 467-110 (KR); Cha, Dong-il, Suwon-si, Gyeonggi-do 441-822 (KR)
(72) Inventor: HWANG, Sang-Soo, Seoul 138-854 (KR); LEE, Woo-Jin, Busan 618-710 (KR); SHIN, Ki-Jo, Icheon-si Gyeonggi-do 467-110 (KR); CHA, Dong-Il, Suwon-si Gyeonggi-do 441-822 (KR)
(74) Representative: Louis Pöhlau Lohrentz
(86) International application number: PCT/KR2014/000922
(87) International publication number: WO 2014/119971

(56) References cited:
- EP-A1- 2 159 304
- WO-A1-2012/051485
- JP-A- H11 319 546
- JP-A- 2012 501 537
- KR-A- 20060 117 607
- KR-A- 20110 051 043
- KR-A- 20110 058 527
- US-A1- 2009 081 366
- US-A1- 2009 165 715
- US-A1- 2010 037 820

## Description

### [Technical Field]

The present invention relates to a thin film deposition method, and more particularly, to a thin film deposition method which can improve quality of a thin film, prevent a damage of a substrate, and increase throughput by the atomic layer deposition (ALD).

### [Background Art]

As deposition methods for forming a thin film on a substrate such as a semiconductor wafer (hereinafter, called a 'substrate'), chemical vapor deposition (CVD), atomic layer deposition (ALD), and so on have been used.

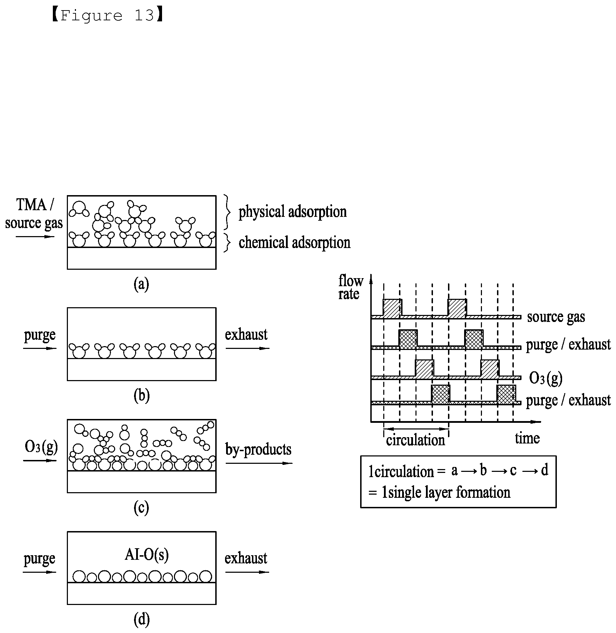

FIG. 13 is a schematic diagram showing the basic concept of atomic layer deposition out of the thin film deposition methods. Referring to FIG. 13, the basic concept of atomic layer deposition is described as below.

First, source gas, such as trimethyl aluminium (TMA), is supplied into a chamber. The source material of source gas adsorbs onto the substrate to form an adsorption layer on the substrate. Then purge gas is supplied to the inside of the chamber. The gas component of source gas which has not adsorbed onto the substrate and the purge gas are exhausted from the chamber. After that, reactant gas is supplied to the inside of the chamber. The reactant gas reacts with the source material adsorbed on the substrate. Then the purge gas is supplied to the inside of the chamber and the reactant gas which has not reacted with the source material and the purge gas are exhausted from the chamber. Through the above-mentioned steps, the thin film layer of one atomic layer is formed on the substrate.

There are various kinds of conventional thin film deposition apparatus used in the atomic layer deposition according to injection directions and methods to inject various gases, such as source gas, reactant gas, purge gas, and others on the surface of the substrate. However, the conventional thin film deposition apparatus has a problem in that they cannot satisfy an excellent quality of the thin film and a substrate throughput simultaneously. In other words, the substrate throughput is remarkably decreased in the case that the excellent quality of the thin film is achieved, and on the contrary, the quality of the thin film declines in the case that the substrate throughput is improved.

Moreover, if a gas activation unit such as a plasma generator is used in order to improve the substrate throughput, activated gas is directly supplied to the substrate, and hence, it causes a damage of the substrate or causes an unnecessary thin film deposition on the edge areas of the substrate.
US 2009/0165715 A1 discloses a vapor deposition reactor.
US 2009/0081366 A1 discloses a delivery device for deposition.
WO 2012/051485 A1 discloses an ALD coating system.

### [Disclosure]

### [Technical Problem]

Accordingly, the present invention has been made in an effort to solve the above-mentioned problems occurring in the prior arts, and it is an object of the present invention to provide a method for controlling a thin film deposition apparatus which can remarkably improve a substrate throughput and enhance the quality of a thin film.

It is another object of the present invention to provide a method for controlling a thin film deposition apparatus which can increase a substrate throughput and reduce the footprint of the conventional thin film deposition apparatus. Moreover, it is a further object of the present invention to provide a method for controlling a thin film deposition apparatus which can prevent a damage of a substrate and also prevent a thin film from being deposited on unnecessary area when activated gas is supplied.

### [Technical Solution]

The object is solved by providing a method for controlling a thin film apparatus according to claim 1. To accomplish the above objects, a thin film deposition apparatus comprises a chamber having a predetermined inner space, a substrate support part disposed inside the chamber and supporting a substrate and a gas supply device having at least one supply channel for supplying process gas to the substrate and an activation channel which has a gas activation unit for activating the process gas, wherein the activation channel has an opened lower portion and a sealed upper portion.

At least one of the gas supply device and the substrate support part in the thin film deposition apparatus performs a relative motion to each other.

The supply channel comprises at least one first supply channel for supplying source gas and at least one second supply channel for supplying reactant gas, and the second supply channel is adjacent to the activation channel.

The gas supply device further comprises a process gas guide part for adjusting an injection direction of the process gas.

The supply channel comprises at least one first supply channel for supplying source gas and at least one second supply channel for supplying reactant gas, and the process gas guide part comprises at least one of a source gas guide part for adjusting an injection direction of the source gas and a reactant gas guide part for adjusting an injection direction of the reactant gas.

The gas supply device further comprises an exhaust channel for exhausting the process gas between the substrate and the gas supply device. The gas supply device comprises internal exhaust channels disposed symmetrically to the first supply channel for exhausting the residual gas.

The second supply channels are disposed symmetrically to the first supply channel.

The gas supply device further comprises an external exhaust channel disposed at the outside of the activation channel.

The supply channel comprises at least one first supply channel for supplying source gas and at least one second supply channel for supplying reactant gas, and the gas supply device comprises an internal exhaust channel disposed at one side of the first supply channel, and the internal exhaust channel is disposed between the first supply channel and the second supply channel.

The gas supply device does not have any exhaust part, which exhausts the residual gas, between the other side of the first supply channel and the second supply channel.

The gas supply device comprises external exhaust channels disposed at one side of the second supply channel for exhausting the residual gas, and the external exhaust channels are disposed symmetrically to the first supply channel.

The gas supply device further comprises at least one of a source gas guide part for adjusting an injection direction of the source gas and a reactant gas guide part for adjusting an injection direction of the reactant gas.

The process gas supplied from the supply channel is introduced into the activation channel through the opening portion so as to be activated by the gas activation unit.

The process gas activated by the gas activation unit is supplied onto the substrate through the activation channel so as to activate non-activated process gas between the substrate and the gas supply device.

### [Advantageous Effects]

The thin film deposition apparatus usable in the present invention supplies various gases containing process gas while the substrate or the gas supply device moves along a rectilinear path so as to make uniform deposition on the surface of the substrate, thereby providing a thin film of excellent quality.

Moreover, the gas supply device usable in the present invention includes the plasma generation part of the gas activation unit so as to provide radicals, thereby enhancing the quality of the thin film and reducing the deposition period of time. Particularly, when the radicals are provided, reactant gas for generating radicals is not directly supplied from the upper portion of the chamber to the plasma generation part but is supplied by an 'indirect supply method' that the reactant gas injected from the reactant gas supply channel is supplied to the plasma generation part in an activation channel, thereby preventing a damage of the substrate and providing the thin film of excellent quality.

Additionally, the thin film deposition apparatus usable in the present invention is configured to carry out the step necessary for the deposition process in the main chamber and to stabilize the initial feed amount of the source gas in the auxiliary chamber during the stabilization period, thereby reducing the deposition period of time necessary for deposition and improving the substrate throughput.

### [Description of Drawings]

FIG. 1 is a side sectional view of a thin film deposition apparatus usable in the present invention.
FIG. 2 is a side sectional view showing a structure of a gas supply device of the thin film deposition apparatus.
FIG. 3 is a schematic view showing an activation step of reactant gas of FIG. 2.
FIGS. 4 to 10 are side sectional views showing a structure of a gas supply device of the thin film deposition apparatus.
FIG. 11 is a schematic diagram showing the basic deposition concept of the thin film deposition apparatus.
FIG. 12 is a schematic block diagram of a thin film deposition apparatus according to a further preferred embodiment of the present invention.
FIG. 13 is a schematic diagram showing the basic concept of an atomic layer deposition (ALD) apparatus according to a prior art.

### [Mode for Invention]

Reference will be now made in detail to the preferred embodiments of the present invention with reference to the attached drawings.

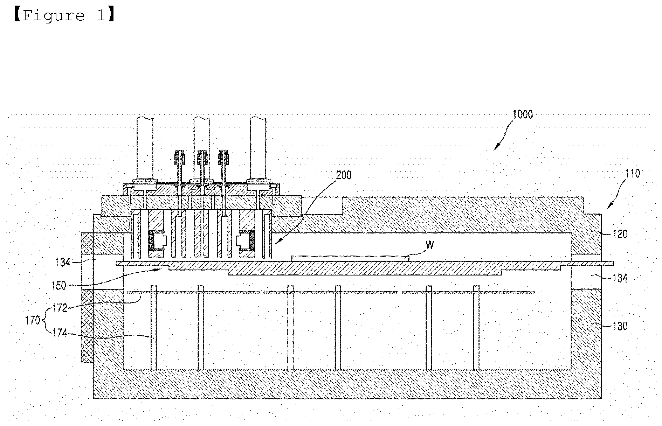

FIG. 1 is a side sectional view showing an internal structure of a thin film deposition apparatus 1000 usable in the present invention.

Referring to FIG. 1, the thin film deposition apparatus 1000 includes: a chamber 110 having a predetermined inner space for carrying out deposition onto a substrate accommodated therein; and substrate loading and unloading means (not shown) for loading and unloading the substrate. In the meantime, not shown in the drawing, but the thin film deposition apparatus may further include: a load lock chamber connected to one side of the chamber 110 for converting into a vacuum state or an atmospheric state; a plurality of boats on which substrates to be deposited are loaded; and a plurality of boats on which substrates completely deposited are loaded.

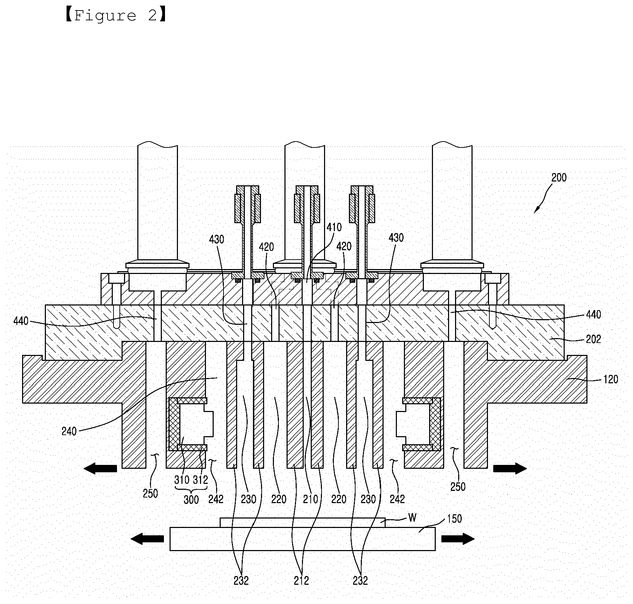

The thin film deposition apparatus 1000 includes: the chamber 110 having a predetermined inner space; a substrate support part 150 which is disposed inside the chamber 110 and supports the substrate (W); and a gas supply device 200. Here, the gas supply device 200 includes: at least one supply channel 210 and 230 for supplying process gas to the substrate (W); and an activation channel 240 having a gas activation unit 300 for activating the process gas(See FIG. 2). The gas supply device 200 is spaced apart from the substrate support part 150 at a predetermined distance so as to perform a relative motion to the substrate support part 150. Moreover, the thin film deposition apparatus may further include substrate loading and unloading means for loading the substrate (W) into the chamber 110 or unloading the substrate (W) from the inside of the chamber 110.

The chamber 110 accommodates the substrate (W) therein for carrying out deposition of the substrate and has a space for mounting various kinds of components. Furthermore, the chamber 110 keeps the inside in a vacuum state by vacuum equipment such as a pump (not shown) for discharging the gas so as to provide the environment for carrying out substrate treating work, such as deposition.

The chamber 110 includes: a chamber body 130 having an inner space and an opened upper portion; and a chamber lid 120 for opening and closing the opened upper portion of the chamber body 130. The chamber body 130 has an opening portion 134 which is disposed at one side thereof and through which the substrate (W) is loaded into and unloaded from the chamber 110.

In the meantime, the gas supply device 200 for supplying at least one of process gas and purge gas is disposed on the chamber lid 120, and the gas supply device 200 will be described later in detail.

The substrate support part 150 supporting the substrate (W) is disposed inside the chamber 110. The substrate support part 150 is configured to perform a relative motion to the gas supply device 200. In other words, at least one of the substrate support part 150 and the gas supply device 200 performs the relative motion to a predetermined distance in parallel with the other one. For instance, all of the gas supply device 200 and the substrate support part 150 may be constructed to perform the relative motion to each other, or one of the substrate support part 150 and the gas supply device 200 may perform the relative motion to the other one. For instance, the substrate support part 150 and the gas supply device 200 may be constructed in such a manner that the gas supply device 200 is fixed and the substrate support part 150 moves or all of the substrate support part 150 and the gas supply device 200 move.

However, In the case of a large-sized or large-surfaced substrate (W), in order to make the substrate (W) move inside the chamber 110, the chamber 110 must be large-sized, but it causes an increase of the whole footprint of the deposition apparatus. Accordingly, in order to carry out deposition even to large-sized or large-surfaced substrate (W), the deposition apparatus may be configured in such a manner that the substrate (W) is fixed and the gas supply device 200 performs the relative motion to the substrate (W) during deposition process. For instance, the gas supply device 200 may be configured to be rectilinearly movable to a predetermined distance in parallel with the substrate (W). Meanwhile, as described above, when the substrate (W) performs the relative motion along a straight path, because the entire surface area of the substrate moves at the same speed, deposition thickness is uniform in the entire surface area during deposition process.

In the meantime, a heating part 170 is disposed below the substrate support part 150. The heating part 170 is disposed at a predetermined distance from the substrate support part 150, which supports the substrate (W), and heats the substrate (W).

In detail, the heating part 170 is disposed along a movement path of the substrate support part 150. The heating part 170 may include, for instance, at least one heating plate 172 and a support portion 174 for supporting the heating plate 172. The heating plate 172 is disposed at a predetermined distance from the substrate support part 150, which supports the substrate (W), in order to heat the substrate (W). Hereinafter, referring to the drawings, the gas supply device 200 will be described in detail.

FIG. 2 is an enlarged sectional view showing a detailed structure of the gas supply device 200. As described above, the substrate support part 150 and the gas supply device 200 may be configured in such a manner that at least one of the substrate support part 150 and the gas supply device 200 performs the relative motion to a predetermined distance in parallel with the other one.

Referring to FIG. 2, the gas supply device 200 includes: at least one supply channel 210 and 230 for supplying process gas to the substrate (W); and an activation channel 240 having a gas activation unit 300 for activating the process gas.

In this embodiment, the gas activation unit 300 activates process gas or reactant gas so as to convert them into the process gas or reactant gas of an activated atom type or a radical type. Here, the gas activation unit 300 may be provided in any one form of a plasma generation part, a microwave generation part, a UV radiation part, and a laser radiation part.

Here, in the case that the gas activation unit 300 is prepared in the form of the microwave generation part, the microwave generation part activates process gas using super high frequency of more than 10⁹Hz. When the microwave generation part applies super high frequency, the process gas is converted into activated atoms or radicals, and then, is injected to the substrate (W).

Moreover, in the case that the gas activation unit 300 is prepared in the form of the UV radiation part, the process gas is converted into activated atoms or radicals by UVs radiated from the UV radiation part, and then, is injected to the substrate (W).

Furthermore, in the case that the gas activation unit 300 is prepared in the form of the laser radiation part, the process gas is converted into activated atoms or radicals by laser radiated from the laser radiation part, and then, is injected to the substrate (W).

Hereinafter, the gas activation unit 300 which is prepared in the form of the plasma generation part will be described. In the case that the gas activation unit 300 is prepared in the form of the plasma generation part, the gas activation unit 300 includes a power source electrode 310 which is disposed on an inner wall of one side of the activation channel 240 and to which gets power supply, and an inner wall of the other side of the activation channel 240 is grounded so as to serve as a ground electrode. In this instance, the gas activation unit 300 has a shielding member 312 disposed on the inner wall of one side of the activation channel 240, and the power source electrode 310 is supported by the shielding member 312. The power source electrode 310 and the gas supply device 200 are electrically separated from each other by the shielding member 312 so that the power source electrode 310 is electrically shielded from the gas supply device 200. In this instance, the shielding member 312 serves as a support part for supporting the power source electrode 310 as well as electrically shields the power source electrode 310.

In this embodiment, the gas supply device 200 is configured in such a manner that the process gas supplied from the supply channel 230 is supplied to the activation channel 240. That is, the gas supply device 200 does not directly supply the process gas or the reactant gas to the activation channel 240 in which the gas activation unit 300 is disposed but adopts an 'indirect supply method' that the process gas or the reactant gas supplied from the supply channel 230 is introduced or supplied into the activation channel 240. As described above, the gas supply device 200 adopts the indirect supply method when it supplies the process gas to the gas activation unit 300 for the following reason.

In general, in the case of apparatus for depositing a substrate by activating process gas utilizing the gas activation unit, the apparatus directly supplies one of process gases, for instance, reactant gas such as O₂, to a space, an area or a channel in which the gas activation unit is disposed. In this instance, the reactant gas is activated by the gas activation unit and supplied to the substrate located below the gas activation unit so as to carry out the deposition process.

However, in the conventional apparatus, because the reactant gas is directly supplied to the space, the area or the channel in which the gas activation unit is disposed, when the reactant gas is activated, an unwanted film may be formed on an inner wall of the gas activation unit and/or the space, the area or the channel. In the case that such a film is formed, because efficiency of the gas activation unit may be considerably reduced, there is a need to periodically remove the film deposited on the area, but it may increase a period of time and costs required for maintaining the deposition apparatus. Furthermore, in the conventional apparatuses, because the reactant gas activated or radicalized by the gas activation unit is directly supplied to the substrate (W), the substrate (W) may be damaged by the activated reactant gas. Therefore, in order to solve the above problem, the gas supply device 200 according to the embodiment of the present invention, in the case that the gas activation unit 300 is disposed, the process gas or the reactant gas is not directly supplied to the gas activation unit 300, but the reactant gas supplied from the supply channel 230 for supplying the reactant gas is introduced or supplied into the activation channel 240.

In detail, the activation channel 240 may have a closed upper portion and an opened lower portion toward the substrate (W) located below the activation channel 240. In this instance, the upper portion of the activation channel 240 may be shielded by a cover 202 for sealing the opening portion of the chamber lid 120. In the meantime, the supply channel 230 and the activation channel 240 may be in neighborhood with each other in the gas supply device 200. In other words, the supply channel 230 is in neighborhood with the activation channel 240, and the process gas and/or the reactant gas supplied through a lower portion of the supply channel 240 is introduced into the neighboring activation channel 240. As described above, the activation channel 240 is opened toward the substrate (W) and includes an opening portion 242 disposed at a lower portion of the activation channel 240 as shown in the drawings, so that the process gas supplied from the supply channel 230 is supplied to the activation channel 240 through the opening portion 242 so as to be activated by the gas activation unit 300. Additionally, the process gas activated by the gas activation unit 300 is supplied onto the substrate (W) through the activation channel 240 so as to activate non-activated process gas flowing between the substrate (W) and the gas supply device 200.

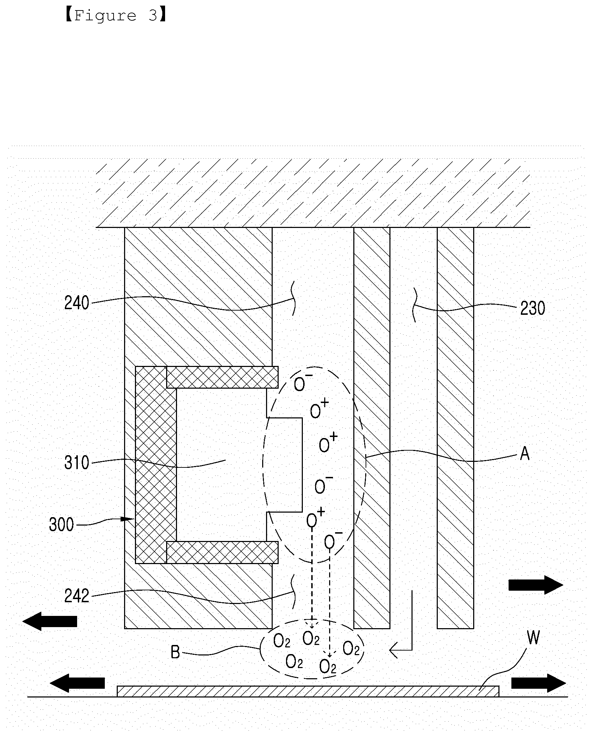

FIG. 3 is a schematic diagram for showing a reaction process that the process gas or the reactant gas is activated in the gas supply device 200.

Referring to FIG. 3, in the case that the gas activation unit 300 is prepared in the form of the plasma generation part, the gas activation unit 300 includes the power source electrode 310 which is disposed on the inner wall of one side of the activation channel 240 and to which power supply is provided, and the inner wall of the other side of the activation channel 240 is grounded so as to serve as a ground electrode.

In this instance, the reactant gas, for instance, O₂ gas, supplied from the neighboring supply channel 230 is introduced into the activation channel 240 through the opening portion 242 formed at the lower portion of the activation channel 240 while flowing along the upper part of the substrate (W). The O₂ gas introduced into the activation channel 240 is activated by the gas activation unit 300 and is converted into activated atoms or radicals. As described above, the O₂ gas converted into the activated atoms or radicals has influence on neighboring O₂ gases so that the neighboring O₂ gases are also converted into activated atoms or radicals. Accordingly, the O₂ gas directly activated by the gas activation unit 300 exists in an area (A) adjacent to the gas activation unit 300, and the O₂ gas indirectly activated by the radicalized gas exists in an area (B) which is somewhat spaced apart from the gas activation unit 300, for instance, in a lower area of the activation channel 240 or an area between the activation channel 240 and the substrate (W). Finally, the gas is activated in the form of a direct plasma in the area (A) adjacent to the gas activation unit 300, and the gas is activated in the form of a remote plasma in the area (B) somewhat spaced apart from the gas activation unit 300. Therefore, the reactant gas not in the form of the direct plasma but in the form of the remote plasma is supplied to the substrate (W). As described above, in the case that the reactant gas in the form of the remote plasma is supplied, it is possible to prevent a damage of the substrate (W). Meanwhile, in this embodiment, because the process gas or the reactant gas is not directly supplied to the activation unit 300, it can minimize the film deposited on the gas activation unit 300. Finally, the embodiment of the present invention can solve the problems occurring in the gas activation unit of the conventional gas supply device. Hereinafter, referring to FIG. 2, the structure of the gas supply device 200 will be described in more detail.

Referring to FIG. 2, the gas supply device 200 includes the cover 202 for sealing the opening portion of the chamber lid 120.

The cover 202 is disposed on the chamber lid 120 in order to seal the opening portion of the chamber lid 120. Therefore, not shown in the drawing, a gasket (not shown) for sealing a gap between the cover 202 and the chamber lid 120 may be disposed. The cover 202 may include various conduits for supplying process gas to the supply channel 210 and 230, which will be described later, or discharging exhaust gas.

In detail, the cover 202 may include a first supply conduit 410 for supplying source gas (or a first process gas). The first supply conduit 410 is connected with a source gas supply source (not shown) so as to supply the source gas to a first supply channel 210 of the gas supply device 200 which will be described later. Moreover, the cover 202 may further include a second supply conduit 430 for supplying reactant gas (or a second process gas). The second supply conduit 430 is connected with a reactant gas supply source (not shown) so as to supply the reactant gas to a second supply channel 230. Furthermore, the cover 202 may further include exhaust conduits 420 and 440 for exhausting the process gas supplied from the supply channels 210 and 230. The exhaust conduits 420 and 440 is connected with a pumping part (not shown) in order to exhaust residual gas inside the chamber 110 by a pumping action of the pumping part.

As described above, the gas supply device 200 includes the supply channels 210 and 230 for supplying the process gas, namely, the source gas and/or the reactant gas. At least one of the supply channels 210 and 230 is disposed in the gas supply device 200, and preferably, a plurality of the supply channels are disposed. The supply channel may include at least one first supply channel 210 for supplying source gas and at least one second supply channel 230 for supplying reactant gas. Moreover, the gas supply device 200 may further include exhaust channels 220 and 250 for exhausting the process gas flowing between the substrate (W) and the gas supply device 200.

The gas supply device 200 according to this embodiment includes the first supply channel 210 disposed at the center for supplying source gas and may be configured symmetrically on the basis of the first supply channel 210. In detail, the gas supply device 200 includes a first supply unit 212 and the first supply channel 210 disposed in the inner face of the first supply unit 212.

The above structure is favorable in the case that the relative motion of the substrate (W) and the gas supply device 200 is a reciprocating motion to reciprocate a predetermined distance. For instance, when the substrate (W) reciprocates along the rectilinear movement path of a predetermined length, even in the case that just one gas supply device 200 is disposed, the substrate (W) moving along the lower portion of the gas supply device 200 can be deposited sufficiently. Additionally, when the substrate (W) reciprocates in one direction and in the opposite direction, it is favorable that the gas supply device 200 is formed symmetrically on the basis of the first supply channel 210 of the center thereof so that the substrate (W) is deposited even though it moves in any direction.

The first supply channel 210 receives the source gas from the first supply conduit 410 and supplies the source gas to the substrate (W) located below the first supply channel 210. In the meantime, the gas supply device 200 may include a pair of internal exhaust channels 220 disposed at both sides of the first supply channel 210 for exhausting residual gas. In order to prevent the source gas supplied from the first supply channel 210 from being mixed with the reactant gas which will be described later, a pair of the exhaust channels 220 are disposed symmetrically on the basis of the first supply channel 210.

The gas supply device 200 may include a second supply channel 230 for supplying reactant gas adjacent to the internal exhaust channel 220. In the embodiment of the invention, the second supply channels 230 are disposed symmetrically on the basis of the first supply channel 210. The second supply channel 230 receives the reactant gas from the second supply conduit 430 and supplies it to the substrate (W) located below the second supply channel 230. In detail, the gas supply device 200 includes a second supply unit 232 and the second supply channel 230 disposed inside the second supply unit 232.

In this case, the internal exhaust channel 220 is disposed in a space between the first supply unit 212 and the second supply unit 232. That is, the embodiment does not need additional unit for the internal exhaust channel 220 so as to reduce material costs for the gas supply device and reduce the entire volume.

Moreover, the gas supply device 200 may include the activation channel 240 adjacent to the second supply channel 230. The activation channel 240 is sealed at an upper portion thereof and an opening portion 242 disposed at a lower portion thereof, such that the activation channel 240 is opened toward the substrate (W). As described above, the activation channel 240 has the gas activation unit 300 for activating reactant gas, and supplies the reactant gas that the reactant gas supplied from the neighboring second supply channel 230 is introduced into the activation channel 240 through the opening portion 242 and then is activated. The structure and operation of the activation channel 240 have been described above, and hence, the repeated description will be omitted. Meanwhile, not shown in the drawings, but the activation channel may be disposed between the first supply channel and the second supply channel, namely, between the first supply unit and the second supply unit.

Accordingly, in the gas supply device 200, the internal exhaust channel 220 for exhausting the residual gas and the second supply channel 230 for supplying reactant gas are disposed symmetrically on the basis of the first supply channel 210, and the activation channel 240 is disposed adjacent to the second supply channel 230.

In the meantime, the gas supply device 200 may further include an external exhaust channel 250 disposed at the outside of the activation channel 240 for exhausting the residual gas. The reactant gas supplied from the second supply channel 230 is introduced into the activation channel 240 through the lower portion of the activation channel 240 or is supplied to an edge of the gas supply device 200 after passing through the activation channel 240. In the case that deposition is carried out by the relative motion of the substrate (W) and the gas supply device 200, when the reactant gas leaks out from the gas supply device 200, it may deteriorate efficiency of the next deposition process. Therefore, the external exhaust channel 250 is disposed at the edge of the gas supply device 200, namely, at the outside of the activation channel 240, so as to exhaust the residual gas, namely, the supplied reactant gas.

Finally, the gas supply device 200 is disposed symmetrically on the basis of the first supply channel 210 which is located at the center for supplying source gas, and includes the internal exhaust channel 220, the second supply channel 230 for supplying reactant gas, the activation unit 240 having the gas activation unit 300 for activating the reactant gas, and the external exhaust channel 250 in order.

The source gas supplied from the first supply channel 210 forms a single molecular layer on the upper portion of the substrate (W) and is exhausted through the internal exhaust channel 220. Continuously, the reactant gas supplied to the substrate (W) through the second supply channel 230 moves along the upper portion of the substrate (W) and is introduced into the activation channel 240 through the opening portion 242 of the neighboring activation channel 240. The reactant gas introduced into the activation channel 240 is activated by the gas activation unit 300 and the reactant gas located below the activation channel 240 is also activated by a sequential reaction, and then, reacts with the source materials of the substrate (W) so as to form a thin film of the single atomic layer. The residual gas passing through the activation channel 240 is exhausted by the external exhaust channel 250.

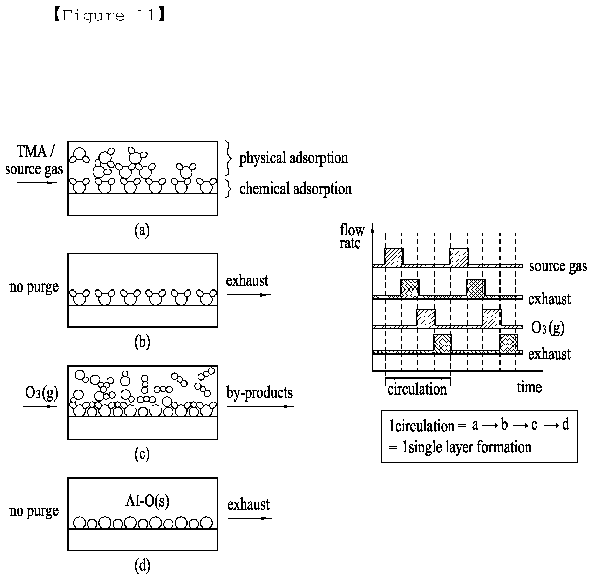

In the meantime, the gas supply device 200 does not supply purge gas containing non-activated gas, such as argon (Ar). FIG. 11 is a schematic diagram showing the basic deposition concept of the thin film deposition apparatus according to embodiment of the present invention. Referring to FIG. 11, the thin film deposition apparatus usable in the present invention injects the source gas containing source materials onto the substrate, and then, simply exhausts unreacted residual gas without supplying non-activated purge gas. Therefore, the thin film deposition apparatus usable in the present invention forms the single atomic layer (Al-O) on the substrate by injecting the reactant gas containing reactants, such as ozone(O₃) reacting with the source materials, and simply exhausting the unreacted materials/by-products without supplying the non-activated purge gas. Accordingly, the embodiment of the present invention does not need a supply of purge gas because it is sufficient to exhaust the residual gas through the simple exhaust process to thereby prevent the reactant gas and the source gas from being mixed together.

Now, deposition process of the thin film deposition apparatus having the above structure will be described as follows.

First, the thin film deposition apparatus 1000 supplies source gas onto the substrate (W) by the gas supply device 200 in such a manner that the source gas is adsorbed on the substrate (W). In this instance, the source gas is supplied onto the substrate (W) through the first supply channel 210 of the gas supply device 200. The source gas supplied onto the substrate (W) is adsorbed to the substrate (W). The source gas which is not adsorbed to the substrate (W) is exhausted out by the internal exhaust channel 220 of the gas supply device 200.

In the meantime, reactant gas is supplied onto the substrate (W) from the gas supply device 200. In this instance, the reactant gas is supplied onto the substrate (W) from the second supply channel 230 of the gas supply device 200. As described above, the reactant gas supplied onto the substrate (W) flows along the space between the substrate (W) and the gas supply device 200, and some of the reactant gas is introduced into the activation channel 240.

Here, the reactant gas injected onto the substrate (W) and flowing between the substrate (W) and the gas supply device 200 is activated. The activation step includes: a first activation step of first activating the reactant gas by the gas activation unit 300 disposed in the gas supply device 200; and a second activation step of second activating the reactant gas between the substrate (W) and the gas supply device 200 by the first activated reactant gas in the first activation step. That is, in the first activation step, the reactant gas introduced into the activation channel 240 is directly activated by the gas activation unit 300. After that, in the second activation step, the reactant gas activated in the first activation step indirectly activates the non-activated reactant gas flowing between the substrate (W) and the gas supply device 200.

Next, the second activated reactant gas has a chemical reaction with the source materials adsorbed on the substrate (W) so as to form a thin film of a single atomic layer. The gas remaining after the thin film deposition is exhausted by the internal and/or external exhaust channel 220, 250. Meanwhile, in the above steps, at least one of the substrate (W) and the gas supply device 200 performs the relative motion to the other one.

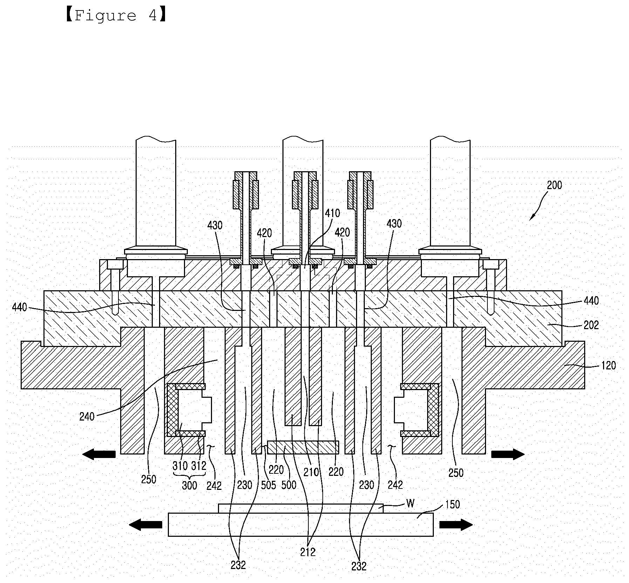

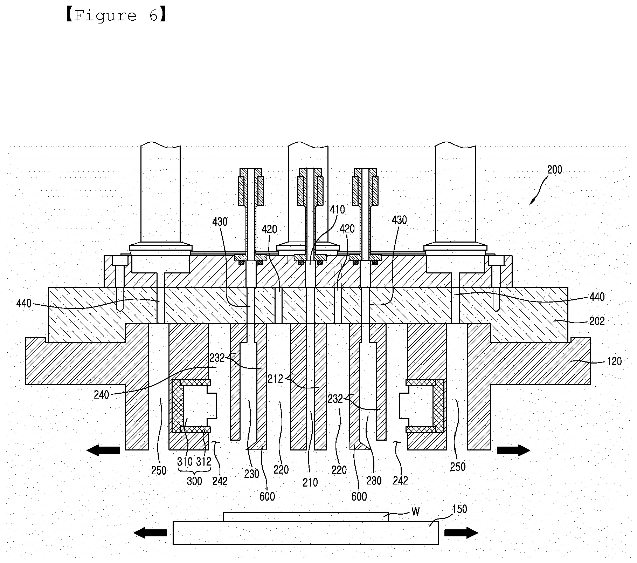

In the meantime, the atomic layer deposition is to adsorb a single molecular layer on the substrate by injecting source gas, such as trimethyl aluminium (hereinafter, called 'TMA'), on the substrate and to form a single atomic layer (A1-O) on the substrate by injecting reactant gas containing reactants, such as ozone (O₃). Accordingly, in the atomic layer deposition, it is important to adjust an amount of the supplied process gas, especially, to adjust a supply amount of TMA which is the source gas. In other words, the atomic layer deposition forms the single atomic layer by just one deposition process, and a thin film of a wanted thickness can be formed when the deposition process is repeated. If not the single atomic layer but plural atomic layers are formed by the one deposition process, it cannot guarantee the quality of the thin film and it is difficult to adjust the thickness of the thin film according to the number of the deposition processes. In order to form the single atomic layer, when TMA is supplied, it is important to prevent TMA from being supplied more than a necessary feed flow rate during the deposition process. If the TMA is supplied more than the necessary feed flow rate, plural molecular layers may be formed on the substrate. In order to supply the TMA less than the feed flow rate, the source gas supply source or the first supply conduit which supplies the TMA must be controlled. However, because the TMA is pressurized and supplied by vapor pressure, it may be difficult to reduce the supplied amount to less than the feed flow rate. Moreover, in the case of the thin film deposition apparatus by the atomic layer deposition, it is important to prevent the source gas and reactant gas supplied to the substrate (W) from being directly mixed with each other. Therefore, hereinafter, another preferred embodiment of the thin film deposition apparatus which includes a process gas guide part for adjusting a feed amount of the source gas and adjusting an injection direction of the process gas to prevent mixing of the source gas and the reactant gas will be described. The process gas guide part may include at least one of a source gas guide part 500 (See FIG. 4) for adjusting the injection direction of the source gas and a reactant gas guide part 600 (See FIG. 6) for adjusting the injection direction of the reactant gas. Hereinafter, the process gas guide part will be described in more detail.

FIG. 4 is a side sectional view showing a structure of a gas supply device usable in the present invention. This embodiment is different from the above-mentioned embodiments in that the thin film deposition apparatus further includes the source gas guide part 500 below the first supply channel 210.

Referring to FIG. 4, the gas supply device 200 according to this embodiment further includes a source gas guide part 500 for adjusting an injection direction of source gas so as to adjust an injected amount or a feed amount of the source gas to the substrate (W).

For instance, the source gas guide part 500 is disposed below a first supply unit 212 having a first supply channel 210 and is disposed perpendicularly to the first supply channel. In this instance, internal exhaust channels 220 for exhausting the supplied source gas are disposed at both sides of the first supply channel 210, and a supply slit 505 having a predetermined size is formed between the source gas guide part 500 and the inner wall of the internal exhaust channel 220, namely the outer wall of a second supply unit 232. Accordingly, the source gas supplied through the first supply channel 210 is curved in its direction by the source gas guide part 500, so that a relative high amount of the source gas is exhausted through the internal exhaust channel 220 and a relative low amount of the source gas is supplied to the substrate (W) through the supply slit 505. Finally, through the source gas guide part 500 located below the first supply unit 212, the thin film deposition apparatus usable in the present invention can reduce a feed amount of the source gas by adjusting the injection direction of the source gas supplied to the substrate (W) .

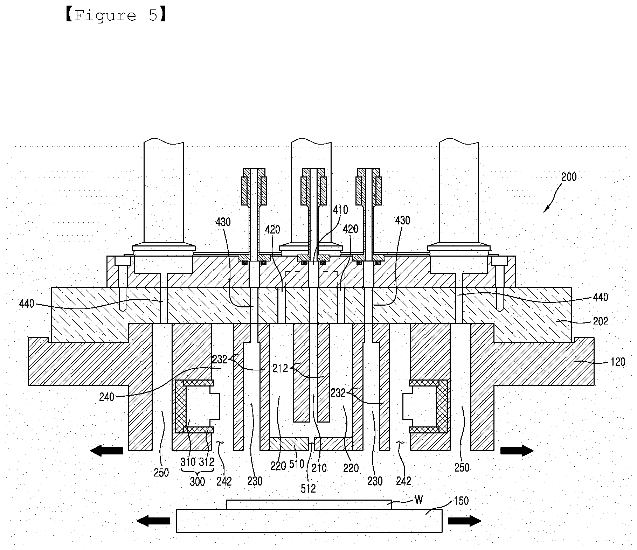

Meanwhile, FIG. 5 illustrates a structure of a source gas guide part 510 according to another preferred embodiment of the present invention. This embodiment is different from the embodiment of FIG. 4 in that the source gas guide part 510 is spaced apart from a first supply unit 212 and is connected to an end portion of an internal exhaust channel 220. In this instance, the source gas guide part 510 may be extended from an end portion of the internal exhaust channel 220, namely, an end portion of a second supply unit 232, toward a first supply channel 210.

Referring to FIG. 5, the first supply channel 210 is shorter than the internal exhaust channel 220, and the source gas guide part 510 protrudes from the outer wall of the second supply unit 232 toward the first supply channel 210. A pair of the source gas guide parts 510 respectively protrude from the outer wall of the second supply unit 232 toward the first supply channel 210, and a space between the source gas guide parts 510 serves as a supply slit 512 for supplying the source gas. Therefore, the source gas supplied from the first supply channel 210 is diffused to the space between the first supply channel 210 and the source gas guide part 510. The relatively high amount of gas is exhausted through the internal exhaust channel 220 and the relative low amount of gas is supplied to the substrate (W) through the supply slit 512.

In the meantime, the source gas guide parts 500 and 510 may be formed integrally with the first supply unit 212 having the first supply channel 210 or may be connected to the first supply unit 212 by means of a separate member.

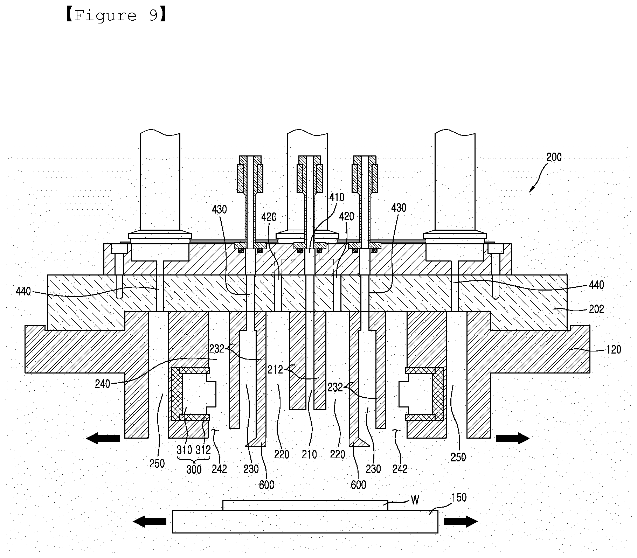

FIGS. 6 to 9 illustrate a gas supply device for preventing mixing of reactant gas and source gas and guiding an injection direction of the reactant gas and/or the source gas according to another embodiment usable in the present invention. In the drawings, the gas supply device 200 may further include a reactant gas guide part 600 for preventing the reactant gas supplied from a second supply channel 230 from being mixed with the source gas and for guiding the reactant gas to face an activation channel 240. FIGS. 6 to 8 respectively illustrate embodiments that the reactant gas guide part 600 is additionally disposed in the gas supply device of FIGS. 2, 4 and 5. Furthermore, FIG. 9 illustrates another embodiment that the first supply channel 210 is relatively shorter than the internal exhaust channel 220 in order to prevent the source gas and the reactant gas from being directly mixed with each other and that the reactant gas guide part 600 is disposed.

Referring to FIGS. 6 to 9, the reactant gas guide part 600 is disposed at an end portion of the second supply unit 232 having the second supply channel 230 for supplying the reactant gas and guides a flow path of the reactant gas supplied from the second supply channel 230 to face the activation channel 240.

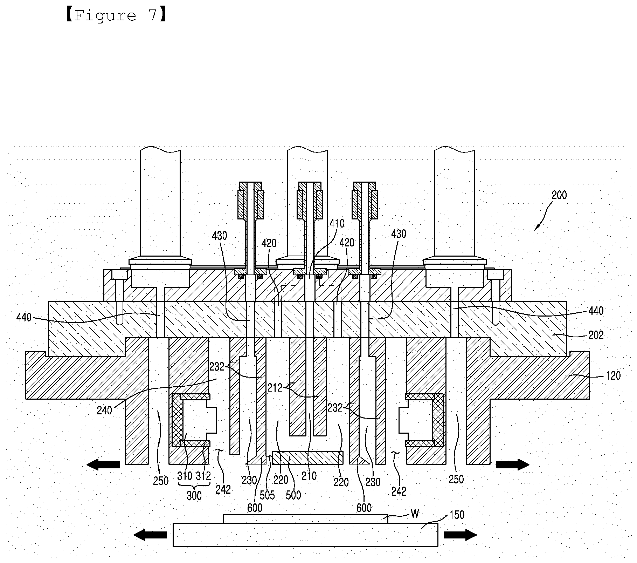

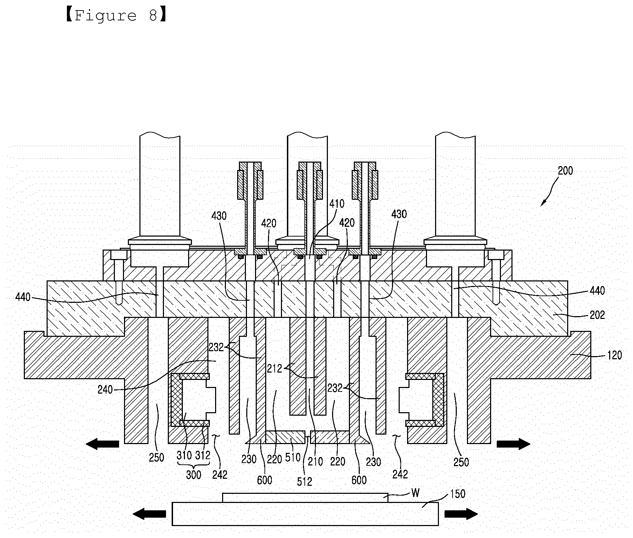

In detail, the reactant gas guide part 600 may protrude to a predetermined length from the second supply unit 232 having the second supply channel 230 toward the activation channel 240. Therefore, the reactant gas supplied from the second supply channel 230 is not mixed with the source gas but faces the activation channel 240. The reactant gas guide part 600 may be formed integrally with the second supply unit 232 having the second supply channel 230 or may be connected to the second supply unit 232 by means of a separate member. Meanwhile, the source gas guide parts 500 and 510 of FIGS. 7 and 8 have been described above, and hence, the repeated description will be omitted.

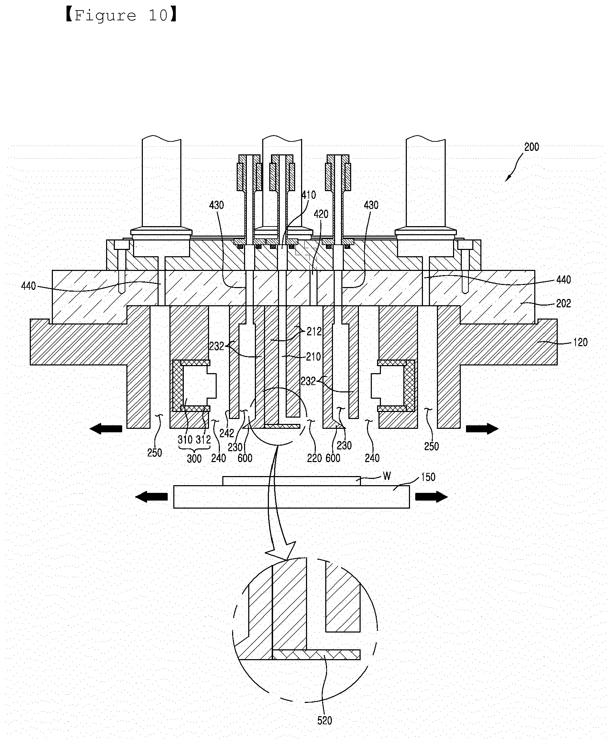

FIG. 10 is a side sectional view of a gas supply device 200 according to another embodiment usable in the present invention. This embodiment is different from the above-mentioned embodiments in that not a pair of the internal exhaust channels 220 but just one internal exhaust channel 220 for exhausting the source gas is disposed.

Referring to FIG. 10, the gas supply device 200 includes: a first supply channel 210 for supplying source gas; at least one second supply channel 230 for supplying reactant gas; an internal exhaust channel 220 disposed at one side of the first supply channel 21, the internal exhaust channel 220 being disposed between the first supply channel 210 and a second supply channel 230; and an external exhaust channel 250 arranged at one side of the second supply channel 230 for exhausting the residual gas. In this instance, an end portion of the internal exhaust channel 220 is communicated with an end portion of the first supply channel 210. Additionally, the second supply channel 230 and the external exhaust channel 250 may be arranged symmetrically on the basis of the first supply channel 210.

In detail, the internal exhaust channel 220 for exhausting the source gas is disposed at one side of the first supply channel 210 for supplying the source gas which is one of process gases. That is, differently from the above-mentioned embodiments, the thin film deposition apparatus according to this embodiment does not have a pair of the exhaust channels at both sides of the first supply channel 210 but has one internal exhaust channel 220 only at one side of the first supply channel 210. Referring to FIG. 10, the internal exhaust channel 220 is disposed at the right side of the first supply channel 210. However, of course, the embodiment usable in the present invention is not restricted to the above and the internal exhaust channel may be disposed at the left side of the first supply channel 210.

Meanwhile, the first supply channel 210 and the at least one second supply channel 230 may abut on each other. That is, in the case that there is one internal exhaust channel 220, at the side where the internal exhaust channel 220 is not disposed, the first supply channel 210 and the second supply channel 230 abut on each other, and in more detail, the first supply unit 212 having the first supply channel 210 and the second supply unit 232 having the second supply channel 230 abut on each other. Moreover, at the other side of the first supply channel 210 where the internal exhaust channel 220 is not disposed, namely, between the other side of the first supply channel 210 and the second supply channel 230, any exhaust part for exhausting the residual gas is not disposed. As described above, because the exhaust channel is disposed only at one side of the first supply channel 210, the entire structure of the gas supply device 200 can be more simplified, and hence, the entire volume of the gas supply device 200 can be reduced.

However, in the above structure, because the internal exhaust channel 20 is disposed at one side of the first supply channel 210, namely, only at the right side of the first supply channel 210, the source gas may not be exhausted sufficiently according to the movement direction of the substrate (W). In other words, in FIG. 10, when the gas supply device 200 moves to the left (in the case that the substrate (W) moves to the right), the source gas supplied from the first supply channel 210 is exhausted relatively smoothly to the internal exhaust channel 220. On the contrary, when the gas supply device 200 moves to the right (in the case that the substrate (W) moves to the left), the source gas supplied from the first supply channel 210 is not exhausted relatively smoothly to the internal exhaust channel 220. Therefore, in this embodiment, the gas supply device may further include a source gas guide part 520 for changing a movement direction of the source gas supplied from the first supply channel 210.

For instance, the source gas guide part 520 may be extended from an end portion of the first supply unit 212 having the first supply channel 210 toward the internal exhaust channel 220 in a perpendicular direction or in such a way as to be inclined at a predetermined angle. Referring to FIG. 10, the source gas guide part 520 is extended from the end portion of the first supply channel 210 toward the internal exhaust channel 220 in the perpendicular direction, but the embodiment usable in the present invention is not restricted to the above, and may be formed to be inclined upwardly or downwardly. Therefore, the direction that the source gas is supplied or the angle that the source gas is supplied to the substrate (W) can be adjusted according to an inclination angle of the source gas guide part 520. The source gas guide part 520 may be formed integrally with the first supply unit 212 forming the first supply channel 210 or may be connected to the first supply unit 212 by means of a separate member.

The source gas supplied from the first supply channel 210 is changed in its movement direction by the source gas guide part 520 so as to face the internal exhaust channel 220, and hence, a relative high amount of the gas is exhausted to the internal exhaust channel 220 and a relatively low amount of the gas is supplied to the substrate (W). Finally, the thin film deposition apparatus usable in the present invention can change the movement direction of the source gas by the source gas guide part 520 so as to more smoothly exhaust the source gas by the exhaust channel and can reduce the amount of the source gas supplied to the substrate so as to carry out the deposition process more accurately. Meanwhile, the source gas guide part 520 is spaced apart from the first supply unit 212 and is formed at an end portion of the internal exhaust channel 220. In this instance, the source gas guide part 520 extends from the end portion of the internal exhaust channel 220 toward the first supply channel 210.

In the meantime, the gas supply device 200 includes the first supply channel 210 disposed at the center thereof for supplying the source gas and the internal exhaust channels 220 for exhausting the residual gas, and is configured symmetrically on the basis of the first supply channel 210 and the internal exhaust channel 220. Because the second supply channel 230 for supplying reactant gas, the activation channel 240 having the gas activation unit 300, and the external exhaust channel 250 are similar to those of the above-mentioned embodiments, their repeated description will be omitted. Additionally, the gas supply device 200 according to this embodiment may include the reactant gas guide part 600 described above. The repeated description of the reactant gas guide part 600 will be omitted because it is described above.

Meanwhile, in the case of the thin film deposition apparatus by the atomic layer deposition, it is important to improve a substrate throughput, and for this, it is also important to reduce a period of time for deposition. However, in order to carry out the deposition process, for instance, in the case that Al₂O₃ is deposited, TMA is initially supplied, and in this instance, in general, an initial feed amount of TMA is still more than a feed amount necessary for the deposition process, and in some cases, source gas of a gas phase must be supplied but source gas of a liquid phase may be supplied. As described above, if excessive TMA is supplied or the source gas of the liquid phase is supplied, not the single atomic layer but the plural atomic layers may be formed during the deposition process, and hence, it causes deterioration in quality of the thin film and in accuracy of the deposition process. Therefore, in the case that the TMA which is the source gas is supplied, it is necessary to have a period of time to stabilize (hereinafter, called 'stabilization period') the deposition process by reducing the feed amount of the source gas till reaching the necessary feed amount during the deposition process. Finally, during the stabilization period, the deposition process is not carried out actually, and the source gas is exhausted till the feed amount of the source gas is stabilized so as to increase the period of the deposition process. If the deposition period is extended, it causes deterioration in the substrate throughput of the thin film deposition apparatus and deterioration in qualities of the initial thin film, such as R.I, etching rate, film density, and so on. Hereinafter, a thin film deposition apparatus usable in the present invention to solve the above problems will be described.

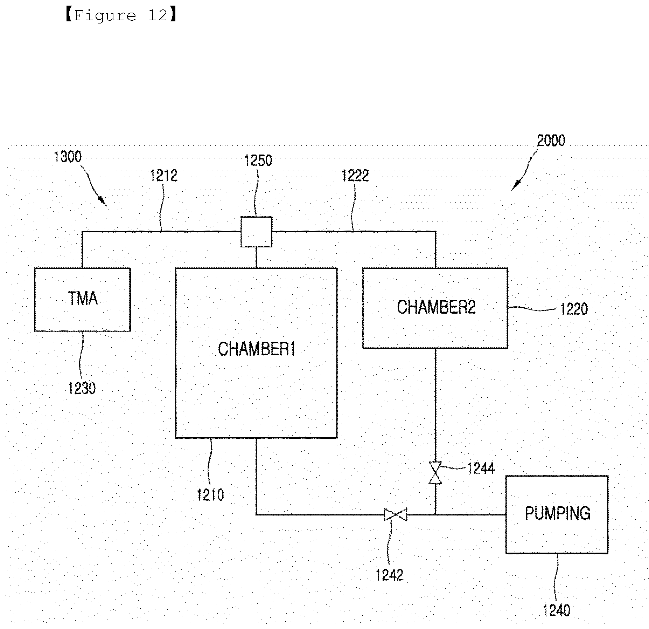

FIG. 12 is a schematic block diagram showing a structure of the thin film deposition apparatus usable in the present invention.

Referring to FIG. 12, the thin film deposition apparatus 2000 includes: a chamber 1210 accommodating a substrate (W) for carrying out a deposition process; an auxiliary chamber 1220 having pressure substantially identical with pressure for carrying out the deposition process in the chamber 1210 or vacuum pressure of a predetermined amount (300mmTorr to 1.2Torr); a source gas supply device 1300 for selectively supplying source gas to the chamber 1210 and the auxiliary chamber 1220; exhaust parts 1240 respectively adapted to exhaust the source gas in the chamber 1210 and the auxiliary chamber 1220; and controlling parts 1242 and 1244 for adjusting an exhaust amount of the exhaust parts 1240.

The chamber 1210 accommodates the substrate (W) therein for carrying out the deposition process, and its description will be omitted because it has been described above.

In the meantime, the auxiliary chamber 1220 has internal pressure substantially identical with the pressure for carrying out the deposition process in the chamber 1210 or vacuum pressure of the predetermined amount (300mmTorr to 1.2Torr). For this, the auxiliary chamber 1220 may have a predetermined space, or may be directly configured inside a piping structure which exhausts gas (not shown in the drawings). In this instance, the bigger the auxiliary chamber 1220 is, the larger the entire footprint of the thin film deposition apparatus 2000 is, and hence, the auxiliary chamber 1220 may be configured to be smaller than the chamber 1210. The auxiliary chamber 1220 has a valve for adjusting pressure of a predetermined amount and a structure that source gas and non-activated gas (Ar, N₂, He, and others) can be put in at the same time.

Meanwhile, the source gas supply device 1300 supplies source gas to the auxiliary chamber 1220 during the stabilization period before supplying the source gas to the chamber 1210. As described above, when TMA which is source gas is initially supplied, if the initial feed amount of TMA is still more than the feed amount necessary for the deposition process, the source gas is first supplied to the auxiliary chamber 1220 till the feed amount of TMA is stabilized. The source gas supplied to the auxiliary chamber 1220 during the stabilization period is exhausted out of the chamber by the exhaust part 1240. Continuously, after a lapse of the stabilization period, when the feed amount of the source gas reaches the feed amount necessary for deposition, the source gas supply device 1300 stops the supply of the source gas to the auxiliary chamber 1220 and supplies the source gas to the chamber 1210. That is, the source gas supply device 1300 supplies the source gas to the auxiliary chamber 1220 during the stabilization period that the feed amount of the source gas reaches the previously determined supply rate, and then, supplies the source gas to the chamber 1210 after the feed amount of the source gas reaches the necessary feed rate.

During the stabilization period to supply the source gas to the auxiliary chamber 1220 by the source gas supply device 1300, necessary steps for the deposition process can be carried out in the chamber. For instance, the substrate (W), on which the thin film is not formed, may be loaded into the chamber 1210. Furthermore, the substrate (W), on which the thin film is formed and which is completed processed, may be unloaded from the chamber 1210 and the internal pressure of the chamber 1210 may be adjusted. During the stabilization period for stabilizing the feed amount of the source gas the source gas is exhausted from the auxiliary chamber. Such exhaust of the auxiliary chamber prevents a phase change of the source gas into a liquid phase by saturated vapor pressure in the source gas supply conduit connected with the chamber so as to prevent a supply of liquid-phase source materials. Finally, the chamber 1210 can carry out a preparation step necessary for the deposition process and stabilize the feed amount of the source gas in the auxiliary chamber 1220, so as to reduce the whole period of time necessary for the deposition process. Accordingly, the thin film deposition usable in the present invention can increase the substrate footprint due to a reduction of the deposition period of time.

The source gas supply device 130 can be realized in various ways, for instance, may include: a source gas storing part 1230 for storing the source gas; a first supply conduit 1212 for connecting the source gas storing part 1230 and the chamber with each other; a second supply conduit 1222 branched from the first supply conduit 1212 for supplying the source gas to the auxiliary chamber 1220; and a valve 1250 for selectively opening the first supply conduit 1212 and the second supply conduit 1222.

Therefore, in the case that the source gas is initially supplied, when a user manipulates the valve 1250, the source gas is supplied to the auxiliary chamber 1220 through the second supply conduit 1222. Next, after a lapse of the stabilization period, when the feed amount of the source gas is stabilized, the user manipulates the valve 1250 again so as to supply the source gas to the chamber 1210 through the first supply conduit 1212.

As described above, while the present invention has been particularly shown and described with reference to the example embodiments thereof, it will be understood by those of ordinary skill in the art that the above embodiments of the present invention are exemplified and various changes, and modifications may be made therein without departing from the technical idea and scope of the present invention as defined by the following claims. Therefore, it would be understood that the changes and modifications of the present invention shall belong to the technical scope of the present invention if they basically include the components and parts defined in the following claims.

## Claims

1. Method of operating a thin film deposition apparatus having a substrate support part (150) being movable inside a chamber (110) and supporting a substrate (W); and
a gas supply device (200) having at least one first supply channel (210) for supplying source gas to the substrate (W), at least one second supply channel (230) for supplying reactant gas and an activation channel (240) being adjacent to the second supply channel (230), wherein the activation channel (240) has a gas activation unit (300) for activating the reactant gas, and wherein the activation channel (300) has an opened lower portion and a sealed upper portion,
the method comprises the steps of:
supplying the source gas onto the substrate (W) through the first supply channel (210) in such manner that the source gas is adsorbed on the substrate (W);
exhausting the source gas which is not adsorbed on the substrate (W);
supplying the reactant gas through the second supply channel (230);
introducing the reactant gas supplied from the second supply channel (230) into the activation channel (240) through the opened lower portion;
activating the reactant gas introduced into the activation channel (240) by the gas activation unit (300); and
supplying the reactant gas activated by the gas activation unit (300) onto the substrate (W) through the activation channel (240).

2. The method of claim 1, further comprising:
activating non-activated reactant gas flowing between the substrate (W) and the gas supply device (200) by the activated reactant gas.

## Patentansprüche

1. Verfahren zum Betreiben einer Dünnfilmabscheidungsvorrichtung mit einem Substratträgerteil (150), das im Inneren einer Kammer (110) beweglich ist und ein Substrat (W) trägt; und
eine Gaszufuhrvorrichtung (200), die mindestens einen ersten Zufuhrkanal (210) zum Zuführen von Basisgas zum Substrat (W), mindestens einen zweiten Zufuhrkanal (230) zum Zuführen von Reaktionsgas und einen Aktivierungskanal (240), der sich neben dem zweiten Zufuhrkanal (230) befindet, aufweist, wobei der Aktivierungskanal (240) eine Gasaktivierungseinrichtung (300) zum Aktivieren des Reaktionsgases aufweist und wobei der Aktivierungskanal (300) einen offenen unteren Bereich und einen geschlossenen oberen Bereich aufweist,
wobei das Verfahren die Stufen umfasst:
Zuführen des Basisgases auf das Substrat (W) durch den ersten Zufuhrkanal (210) in einer solchen Weise, dass das Basisgas am Substrat (W) adsorbiert wird;
Absaugen des Basisgases, das nicht am Substrat (W) adsorbiert worden ist;
Zuführen des Reaktionsgases durch den zweiten Zufuhrkanal (230);
Einleiten des aus dem zweiten Zufuhrkanal (230) zugeführten Reaktionsgases in den Aktivierungskanal (240) durch den offenen unteren Bereich;
Aktivieren des in den Aktivierungskanal (240) eingeleiteten Reaktionsgases durch die Gasaktivierungseinrichtung (300); und
Zuführen des durch die Gasaktivierungseinrichtung (300) aktivierten Reaktionsgases auf das Substrat (W) durch den Aktivierungskanal (240).

2. Verfahren nach Anspruch 1, ferner umfassend:
Aktivieren von nicht-aktiviertem Reaktionsgas, das zwischen dem Substrat (W) und der Gaszufuhrvorrichtung (200) strömt, durch das aktivierte Reaktionsgas.

## Revendications

1. Méthode de fonctionnement d'un appareil de dépôt de film mince comportant une partie de support de substrat (150) étant mobile à l'intérieur d'une chambre (110) et soutenant un substrat (W) ; et
un dispositif de distribution de gaz (200) comportant au moins un premier canal de distribution (210) pour distribuer un gaz source vers le substrat (W), au moins un deuxième canal de distribution (230) pour distribuer un gaz réactif et un canal d'activation (240) étant adjacent au deuxième canal de distribution (230), dans lequel le canal d'activation (240) comporte une unité d'activation de gaz (300) pour activer le gaz réactif, et dans lequel le canal d'activation (300) comporte une partie inférieure ouverte et une partie supérieure scellée,
la méthode comprenant les étapes de :
distribution du gaz source sur le substrat (W) par l'intermédiaire du premier canal de distribution (210) de telle manière que le gaz source est adsorbé sur le substrat (W) ;
l'échappement du gaz source qui n'est pas adsorbé sur le substrat (W) ;
la distribution du gaz réactif par l'intermédiaire du deuxième canal de distribution (230) ;
l'introduction du gaz réactif distribué depuis le deuxième canal de distribution (230) dans le canal d'activation (240) par l'intermédiaire de la partie inférieure ouverte ;
l'activation du gaz réactif introduit dans le canal d'activation (240) par l'unité d'activation de gaz (300) ; et
la distribution du gaz réactif activé par l'unité d'activation de gaz (300) sur le substrat (W) par l'intermédiaire du canal d'activation (240).

2. La méthode selon la revendication 1, comprenant en outre :
l'activation du gaz réactif non activé s'écoulant entre le substrat (W) et le dispositif de distribution de gaz (200) par le gaz réactif activé.
